# EUROPEAN PATENT APPLICATION

(11) **EP 4 290 571 A1**
(43) Date of publication of application: **13.12.2023**
(21) Application number: 22178335.0
(22) Date of filing: 10.06.2022
(51) Int. Cl.: H01L 23/31, H01L 23/495

(54) **ELECTRONIC PACKAGE WITH HEATSINK AND MANUFACTURING METHOD THEREFOR**

(71) Applicant: Nexperia B.V., 6534 AB Nijmegen (NL)
(72) Inventor: Tan, Wei Leong, Seremban (MY); Lee, Wai Wai, Seremban (MY); Cheam, Hing Suan, Seremban (MY)
(74) Representative: Pjanovic, Ilija

(57) **Abstract**

Aspects of the present disclosure generally relate to an electronic package and to a method for manufacturing the same. The electronic package comprises a first substrate, an electronic component arranged on and/or formed in the first substrate, a thermally conductive second substrate comprising a first portion and a second portion integrally connected to the first portion, wherein at least the first portion among the first and second portion is fixedly attached to the electronic component, and a package material arranged to encapsulate the electronic component and to at least partially encapsulate the first and second substrate, wherein the package material comprises a recess formed therein that extends up to a surface of the first portion.

## Description

### FIELD

Aspects of the present disclosure generally relate to an electronic package and to a method for manufacturing the same.

### BACKGROUND

Electronic components, such as semiconductor dies, may be arranged inside an electronic package to protect said electronic components from external damages, for example due to mechanical stress. In a molded electronic package, an electronic component can be encapsulated by a package material, such as a body of solidified molding compound, arranged to protect said electronic component.

The electronic package described above may be subject to thermal stress due to heat dissipated in the electronic component during operation. To partially alleviate this thermal stress, a thermally conductive substrate may be fixedly attached to electronic component, said substrate being configured to conduct heat from the electronic component to an outside of the electronic package. Said thermally conductive substrate may thus correspond to or form at least part of a heatsink of the electronic package.

In known manufacturing methods, the package material is arranged to encapsulate the electronic component and the thermally conductive substrate. Subsequently, the package material is subjected to a grinding process to expose the thermally conductive substrate to an outside of the electronic package.

A drawback of the known manufacturing method is that it typically involves a long processing time to achieve a good planar uniformity between the package material and the surface of the thermally conductive substrate. Additionally, the substrate should be substantially flat to minimize a risk of damage during the known manufacturing process. Moreover, defects such as scratches or more severe damages may occur due to mechanical stress induced on the package during the known manufacturing process.

### SUMMARY

Aspects of the present disclosure relate to a semiconductor device package and a method for manufacturing the same, in which the abovementioned drawback(s) do not occur, or hardly so.

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, an electronic package is provided. The electronic package comprises a first substrate, an electronic component arranged on and/or formed in the first substrate, a thermally conductive second substrate comprising a first portion and a second portion integrally connected to the first portion, wherein at least the first portion among the first and second portion is fixedly attached to the electronic component, and a package material arranged to encapsulate the electronic component and to at least partially encapsulate the first and second substrate, wherein the package material comprises a recess formed therein that extends up to a surface of the first portion.

In the electronic package according to the present disclosure, the recess may be formed to only extend to a desired portion of the second substrate, compared to grinding which uniformly removes a portion of the package material near the second substrate. Furthermore, the electronic package according to the present disclosure can be manufactured more efficiently and a mechanical stress induced on the package during manufacturing can be reduced.

The electronic package may further comprise a conductive coating and/or layer stack arranged in the recess on the surface of the first portion. In a further embodiment, the conductive coating and/or layer stack may comprise tin.

Viewed in a direction in which the recess extends towards the first portion, a contour of the recess may be formed to allow unique identification of an orientation of the electronic package viewed in said direction. In doing so, the step of providing orientation indication can be conveniently combined with the step of forming the recess during manufacturing, which can lead to a reduced manufacturing time. The orientation of the electronic package may facilitate identifying pins or leads of the electronic package and to which terminal of the electronic component they belong, which can be useful during mounting of the electronic package to an external surface, such as a printed circuit board (PCB).

The second substrate may be attached to the electronic component using an attaching material, such as tin. In a further embodiment, the second portion may comprise an overflow recess or hole facing the electronic component, wherein the attaching material preferably occupies at least part of said overflow recess or hole. Additionally or alternatively, the second substrate may comprise a plurality of protruding portions extending from the second portion to the electronic component defining a space between the electronic component and a remainder of the second substrate, said space being at least partially filled with the attaching material.

In the known electronic package, the second substrate must be substantially flat such that the risk of damaging the package during the grinding process is minimized. In other words, holes and protrusions in the second substrate reduce the manufacturing reliability when using the known manufacturing method.

The electronic package according to the present disclosure does not require using a grinding process. Instead, a recess is formed in the electronic package to only extend to a desired portion of the second substrate. This enables using the second substrate to have one or more overflow recesses or holes which are configured to receive, during manufacturing, overflow attaching material to prevent said attaching material from bleeding to the electronic component. Furthermore, the second substrate according to the present disclosure may have a plurality of protrusions defining a space between the electronic component and a remainder of the second substrate. This space defined by the plurality of protrusions improve the reliability of the electronic package by allowing a particular bond line thickness (BLT) to be achieved more reliably.

The electronic package may comprise a plurality of leads for allowing electrical contact with the electronic package. The second substrate may be comprised in a clip, and the clip may further comprise a lead portion extending from the second portion to at least one lead among the plurality of leads. The lead portion may be electrically or integrally connected to said at least one lead, and the clip may electrically connect a terminal of the electronic component to said at least one lead.

The first substrate may be electrically conductive and may be electrically connected to a second terminal of the electronic component. The first substrate may be configured to allow electrical access to the second terminal of the electronic component.

The electronic component may comprise a semiconductor die, and the first substrate may comprise a die pad. Additionally or alternatively, the package material may comprise a body of solidified molding compound.

According to another aspect of the present disclosure, a method for manufacturing an electronic package is provided. The method comprises a) providing an electronic package comprising a first substrate, an electronic component arranged on and/or formed in the first substrate, a thermally conductive second substrate comprising a first portion and a second portion integrally connected to the first portion, wherein at least the first portion among the first and second portion is fixedly attached to the electronic component, and a package material arranged to encapsulate the electronic component and to at least partially encapsulate the first and second substrate. The method further comprises b) forming a recess in the package material extending up to a surface of the first portion.

The recess according to the present disclosure is formed to only extend to a desired portion of the second substrate, compared to grinding which uniformly removes a portion of the package material near the second substrate. Furthermore, the electronic package according to the present disclosure can be manufactured more efficiently and a mechanical stress induced on the package during manufacturing can be reduced.

The method may further comprise arranging a conductive coating and/or layer stack in the recess on the surface of the first portion. In a further embodiment, the conductive coating and/or layer stack may comprise tin.

Viewed in a direction in which the recess extends towards the first portion, a shape of a contour of the recess may be formed to allow unique identification of an orientation of the electronic package viewed in said direction. In doing so, the step of providing orientation indication can be conveniently combined with the step of forming the recess during manufacturing, which can lead to a reduced manufacturing time. The orientation of the electronic package may facilitate identifying pins or leads of the electronic package and to which terminal of the electronic component they belong, which can be useful during mounting of the electronic package to an external surface, such as a printed circuit board (PCB).

Step b) may comprise arranging a masking layer configured to define a position and shape of the recess, etching the package material using the masking layer, and removing the masking layer, wherein the etching preferably comprises chemical etching and wherein the masking layer preferably comprises a metal such as aluminum or copper. Additionally or alternatively, step b) may comprise applying a laser to laser-remove a portion of the package material.

Compared to a grinding process in the known manufacturing method, forming a recess and removing only a portion of the package material (e.g., using an etching process or a laser-removal process) may induce less mechanical stress on the package during manufacturing and can therefore result in an improved manufacturability and reliability of the package.

Step a) may comprise a1) providing the first substrate, a2) arranging the electronic component on the first substrate, a3) attaching at least the first portion among the first and second portion to the electronic component, and a4) providing the package material. In a further embodiment, step a4) may comprise applying a molding compound and allowing said molding compound to solidify to thereby form a body of solidified molding compound. The body of solidified molding compound may form the package material of the electronic package.

The first substrate may be comprised in a leadframe. The leadframe may comprise a frame portion and a plurality of said first substrates connected to the frame portion for manufacturing a plurality of respective electronic components. The method may further comprise singulating the electronic package from the frame portion after step a4).

The second substrate may be attached to the electronic component using an attaching material, such as tin. In a further embodiment, the second portion may comprise an overflow recess or hole facing the electronic component, wherein the attaching material preferably occupies at least part of said overflow recess or hole. Additionally or alternatively, the second substrate may comprise a plurality of protruding portions extending from the second portion to the electronic component defining a space between the electronic component and a remainder of the second substrate, said space being at least partially filled with the attaching material.

The electronic package may comprise a plurality of leads for allowing electrical contact with the electronic package. The second substrate may be comprised in a clip. The clip may further comprise a lead portion extending from the second portion to at least one lead among the plurality of leads. The lead portion may be electrically or integrally connected to said at least one lead, and the clip may electrically connect a terminal of the electronic component to said at least one lead.

The first substrate may be electrically conductive and may be electrically connected to a second terminal of the electronic component. The first substrate may be configured to allow electrical access to the second terminal of the electronic component.

The electronic component may comprise a semiconductor die, and the first substrate may comprise a die pad.

### DESCRIPTION OF THE DRAWINGS

Next, the present disclosure will be described in more detail with reference to the appended drawings, wherein:
Figures 1A and 1B are perspective views of an electronic package according to an embodiment of the present disclosure;
Figures 2A-2E are cross-sectional views illustrating a method for manufacturing an electronic package according to an embodiment of the present disclosure;
Figures 3A-3D are top views of an electronic package according to various embodiments of the present disclosure;
Figure 4A is a top view of an electronic package according to an embodiment of the present disclosure; and
Figure 4B is a cross-sectional view of the electronic package of Figure 4A.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or" in reference to a list of two or more items covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the detailed description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

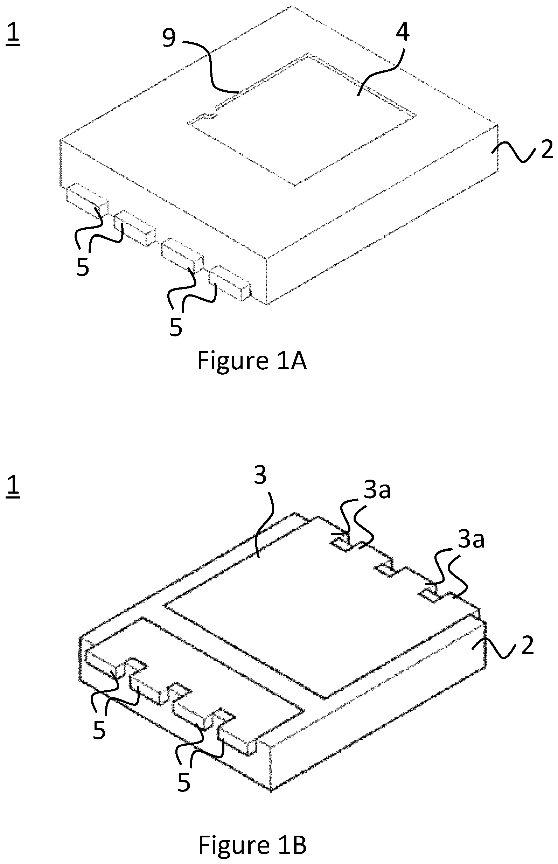

In Figures 1A and 1B, an electronic package 1 according to an embodiment of the present disclosure is shown. Electronic package comprises an electronic component (not visible in Figures 1A and 1B) encapsulated in a package material 2. The electronic component is arranged between a first substrate 3 and a second substrate 4, and is fixedly attached to second substrate 4. First substrate 3 may be a pad on which the electronic component is arranged, and second substrate 4 may be a clip, as will be described further below.

Second substrate 4 is thermally conductive, and first substrate 3 may additionally be thermally conductive. Package material 2 comprises a recess 9 formed therein which extends up to a first portion of second substrate 4. In particular, looking at a top surface of package material 2 in Figure 1A, only a portion of package material 2 is removed such that recess 9 extends up to second substrate 4. As a result, second substrate 4 (or a coating or layer (stack) arranged thereon) can be exposed to an outside of electronic package 1. This enables second substrate 4 to act as a heatsink, or part thereof, for the electronic component comprised in electronic package 1. Furthermore, by removing only a portion of package material 2, only a desired portion of second substrate 4 is exposed, such that electronic package 1 can be manufactured more efficiently and reliably as compared to grinding the entire top surface of package material 2. For example, heat dissipated by the electronic component may be conducted via second substrate 4 to an outside of electronic package 1. In some embodiments, the first portion of second substrate 4 may have a radiator (not shown) arranged thereon, attached thereto or formed therein.

A surface of first substrate 3, or a coating or layer (stack) arranged thereon, may be exposed to an outside of electronic package 1 and may similarly act as and/or form part of a heatsink for electronic package 1. In doing so, a dual-heatsink package can be achieved. That is, each of first substrate 3 and second substrate 4 may be configured to enable conducting heat dissipated by the electronic component to an outside of electronic package 1.

Electronic package 1 further comprises a plurality of leads, each being electrically connected to a terminal of the electronic component, as will be appreciated by the skilled person. For example, each terminal of the electronic component may have at least one lead electrically connected thereto. The leads may be electrically connected to the electronic component via an electrically conductive interconnection (e.g., a metal structure), one or more bondwires, or the like. Said leads may extend to and/or be at least partially arranged at an outside of electronic package 1 for providing electrical access to the electronic component from the outside of electronic package 1.

In some embodiments, first substrate 3 may be electrically conductive and electrically connected to a terminal of the electronic component. In that case, first substrate 3 may form a package contact of electronic package 1. Furthermore, first substrate 3 may comprise one or more protrusions 3a extending from a planar portion of first substrate 3. The one or more protrusions 3a and/or the planar portion may be considered as the package contact (or lead) formed by first substrate 3.

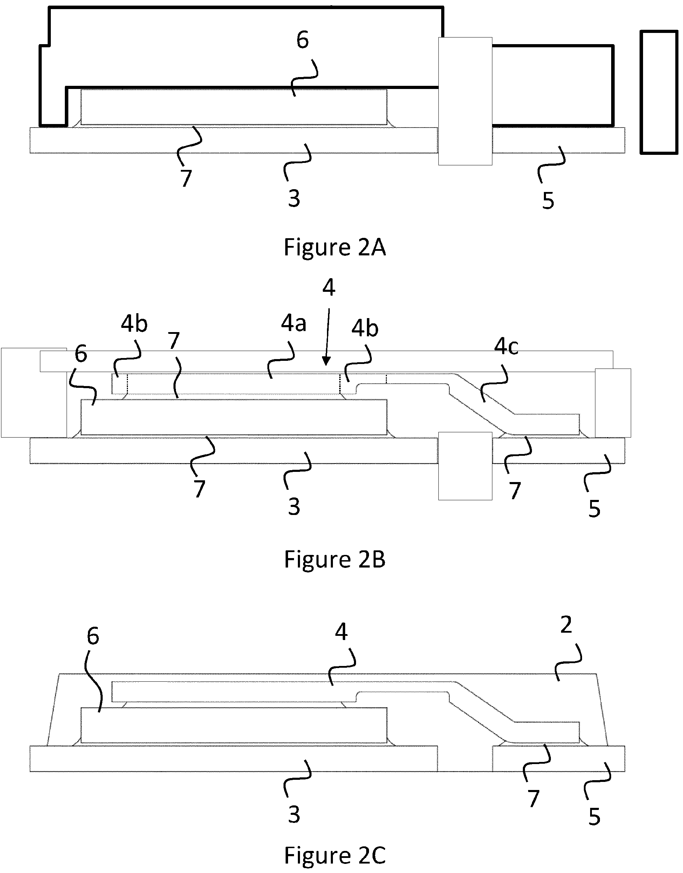

In some embodiments, second substrate 4 may be electrically conductive and may be integrally formed with or electrically connected to one or more leads 5. For example, second substrate 4 may be a clip comprising a planar portion and one or more leads 5 extending from the planar portion to an outside of electronic package 1. Alternatively, second substrate 4 is separate from leads 5 and may be electrically connected to at least one of said leads 5 via a lead portion (not shown in Figures 1A and IB), as described further below with reference to Figures 2B-2E. As shown in Figure 1B, one or more leads 5 may be integrally connected, though the present disclosure is not limited thereto.

The electronic component may for example be a two-terminal device such as a diode, a three-terminal device such as a transistor, e.g., a field-effect transistor (FET) or a bipolar junction transistor (BJT), or a device or circuit with more than three terminals.

In some embodiments, the electronic component may be a semiconductor die having a circuit (e.g., a diode or a transistor) integrated thereon. In that case, first substrate 3 may be a die pad on which the electronic component is arranged.

Next, a method for manufacturing electronic package 1 is described with reference to Figures 2A-2E.

In Figure 2A, first substrate 3 and leads 5 (only one shown) are provided. The method may comprise arranging an electronic component 6 on first substrate 3 and may comprise fixedly attaching electronic component 6 thereto using an attaching material 7. In an example, attaching material 7 comprises a solder material or solder paste, for example comprising tin, or an adhesive material. An attaching material may also be referred to as a bonding material.

First substrate 3 and leads 5 may be provided in a leadframe (not shown) comprising a plurality of said first substrate 3 and a plurality of sets of one or more leads 5 attached to a frame portion (not shown) of the leadframe, as will be appreciated by a person skilled in the art. The leadframe may be used to manufacture a plurality of respective electronic packages consecutively or substantially simultaneously. In an embodiment, a plurality of first substrates 3 are provided in a first leadframe, and a plurality of sets of one or more leads 5 are provided in a second leadframe separate from the first leadframe, though they may also be included in a same leadframe. The plurality of first substrates 3 and sets of one or more leads 5 may be arranged in an array pattern. It is noted that, although Figures 2A-2E show a manufacturing method for a single electronic package, the method may be applied to a plurality of electronic packages that are consecutively or substantially simultaneously formed using the leadframe. The frame portion, first substrate(s) 3 and lead(s) 5 may comprise copper.

In Figure 2B, second substrate 4 is provided. Second substrate 4 comprises a first portion 4a, and a second portion 4b integrally connected to first portion 4a. In an embodiment, first portion 4a and second portion 4b may together form a planar portion of second substrate 4, and second portion 4b may circumferentially surround first portion 4a in a direction perpendicular to the viewing direction of Figure 2B. In other words, first portion 4a may be a central portion of the said planar portion and second portion 4b may be a peripheral portion of said planar portion. At least first portion 4a among first portion 4a and second portion 4b is fixedly attached to electronic component 6, for example using an attaching material 7.

Furthermore, second substrate 4 may be electrically conductive and, as shown in Figures 2B-2E, may be comprised in a clip, the clip further comprising a lead portion 4c extending from the second portion and being electrically connected to one or more leads 5. In some embodiments, at least one lead 5 is integrally connected to second portion 4b or lead portion 4c, and may be comprised in the clip.

In Figure 2C, package material 2 is provided. Package material 2 is arranged to encapsulate electronic component 6 and second substrate 4, and to partially encapsulate first substrate 3. As an example, a thickness of package material 2 on top of second substrate 4 may be in a range between 75 and 100 micrometers. For convenience, in Figures 2C-2E, individual reference signs for the first portion, the second portion and the lead portion are omitted. Furthermore, in Figures 2C-2E, reference signs for the attaching material are omitted.

In an embodiment, package material 2 comprises a body of solidified molding compound. In that case, the manufacturing method may comprise applying a molding compound and allowing said molding compound to solidify to thereby form package material 2 comprising the body of solidified molding compound. A molding tool may be used to form package material 2 into a desired shape during the solidifying of the molding compound.

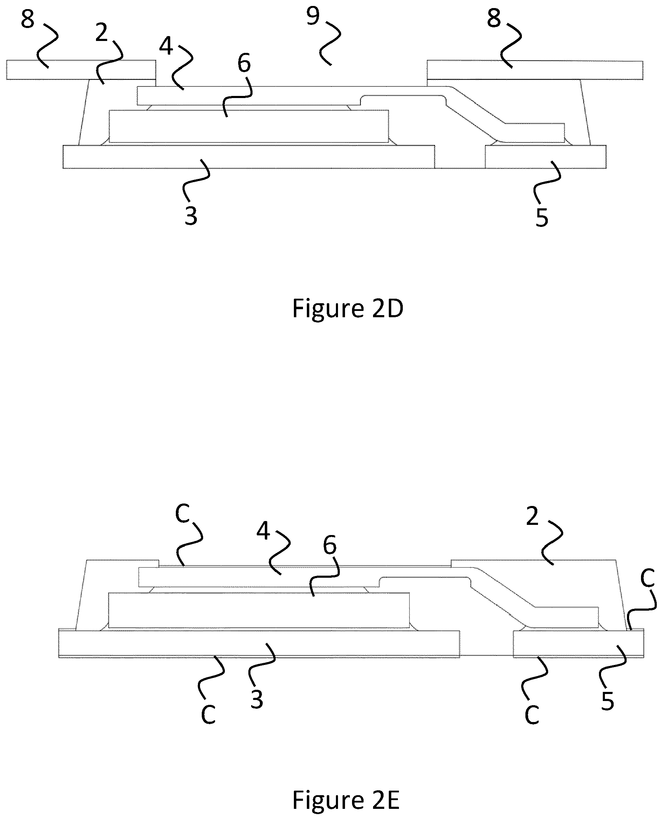

In Figure 2D, a recess 9 is formed in package material 2 extending up to first portion 4a of second substrate 4. Said recess 9 exposes a surface of first portion 4a to an outside of electronic package 1. As described with reference to Figures 1A and 1B, first portion 4a may have a radiator pattern formed therein, or a radiator may be arranged thereon and/or attached thereto after forming recess 9.

A laser removal process may be used to laser-cut recess 9 into package material 2 to thereby form recess 9. For example, a laser removal machine is used in which a laser removal process is programmed to define a position and depth of recess 9.

Alternatively, or additionally, as shown in Figure 2D, a masking layer 8 may be arranged, said masking layer 8 at least partially defining a position of recess 9. Following this, a chemical etching step may be carried out to remove a portion of package material 2, thereby forming recess 9. Masking layer 8 may protect a remaining portion of package material 2 during the chemical etching. The material forming masking layer 8 may comprise a metal stencil such as an aluminum or copper plate. Masking layer 8 may be arranged so as to only expose first portion 4a among first portion 4a and second portion 4b after etching. In doing so, only a desired area of second substrate 4 is exposed by recess 9. After etching, masking layer 8 may be removed.

Finally, in Figure 2E, a plating process is applied to provide a coating or layer on first portion 4a and optionally also on leads 5 and first substrate 3. The coating or layer may comprise tin, and may increase a solderability of the coated surfaces. For example, the coating may facilitate attaching a radiator to first portion 4a. The method may further comprise a deflashing step prior to or after the plating process to remove any remaining etching chemicals or other residues from electronic package 1.

If a (plurality of) leadframe(s) is used as described above, the method may further comprise singulating the electronic package 1 from the leadframe(s) by breaking the connection between first substrate 3 and the frame portion and by the breaking the connection between leads 5 and the frame portion. The breaking action may comprise punching, cutting, sawing, or the like. The singulating step may also be referred to as 'trimming'.

The method may further comprise forming leads 5 into a particular shape, such as a gullwing shape, to enable electronic package 1 to be properly mounted on an external surface, such as a printed circuit board (PCB). When mounted, leads 5 (and, optionally, first substrate 3) may be in contact with electrical connections on or in the external surface connecting electronic package 1 to an external circuit.

In Figures 2B-2E, lead portion 4c is fixedly attached to at least one lead 5 via an attaching material 7, such as a solder material. However, the present invention is not limited thereto. Second substrate 4 does not need to form an electrical connection to a lead, and in some embodiment only forms (part of) a heatsink of electronic package 1. In that case, one or more leads 5 may be electrically connected to terminals electronic component 6 via other means, such as bondwires, as will be appreciated by a person skilled in the art. Each terminal of electronic component 6 may be associated with one or more respective leads 5.

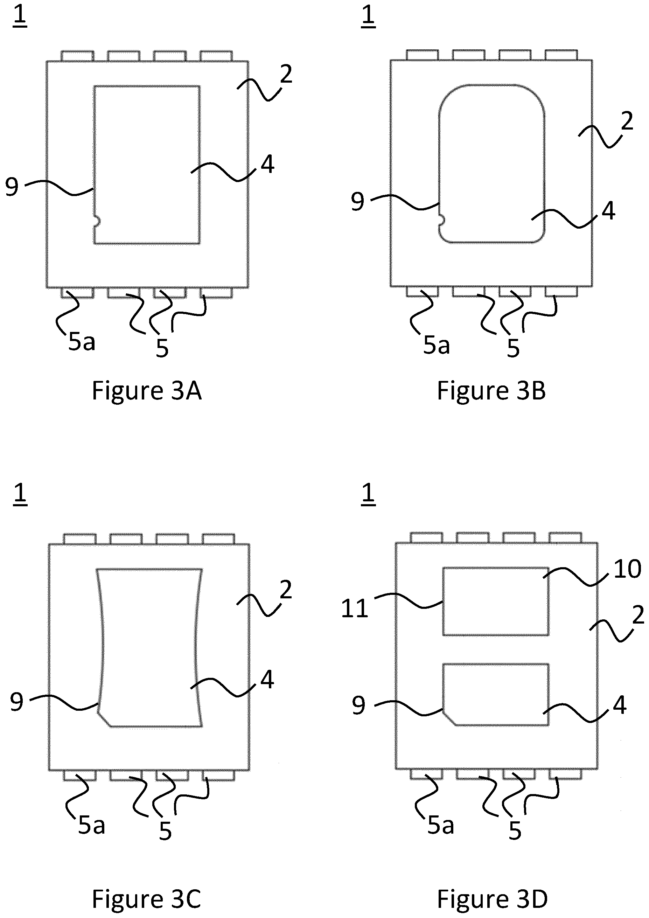

In Figures 3A-3D, various top views of electronic packages 1 are shown in accordance with embodiments of the present disclosure. For convenience, reference signs are shown for only some of the plurality of leads 5.

Viewed from the top of electronic package 1, recess 9 may have a contour which enables unique identification of an orientation of electronic package 1. In an example, the contour of recess 9 may enable unique identification of a primary lead 5a, or 'pin 1', among a plurality of leads 5 of electronic package 1 corresponding to a particular terminal of the electronic component comprised in electronic package 1. As an example only, the electronic component may comprise a FET, and primary lead 5a may be electrically connected to a gate terminal of said FET. Depending on an arrangement of the plurality of leads 5 and their correspondence to terminals of the electronic component, if primary lead 5a can be identified using the contour of recess 9, then all of the plurality of leads 5 can be uniquely identified. This may for example be useful during mounting of electronic package 1 to an external surface in a particular orientation, for example to electrically connect electronic package 1 to an external circuit in a particular way.

The contour of recess 9 may for example comprise an irregularity such as a protruding portion, as shown in Figure 3A, and/or rounded corners having a different radius, as shown in Figure 3B, and/or at least one chamfered corner, as shown in Figures 3C and 3D. More generally, the contour of recess 9 may be asymmetrical in a manner that enables unique identification of the orientation of electronic package 1, e.g., unique identification of primary lead 5a. The present disclosure is not limited to the configurations shown in Figures 3A-3D, and additional or alternative deviations from a symmetrically formed recess are also envisaged.

The contour of recess 9 may for example be defined by masking layer 8 and/or the laser removal program described with reference to Figure 2D. In this manner, unique identification of an orientation of electronic package 1 is enabled conveniently at the same time as forming recess 9, and no additional steps in the manufacturing method are required for the unique identification of the orientation of electronic package 1.

As shown in Figure 3D, the present disclosure is not limited to forming a single recess or using only second substrate 4. For example, electronic package 1 may comprise a further substrate 10 similar or substantially identical to second substrate 4 and may be fixedly attached to the electronic component in a similar manner. A further recess 11 may be formed in package material 2 extending up to a first portion of further substrate 10. Further substrate 10 may thus also function as or form at least part of a heatsink of the electronic component.

Further substrate 10 may also be electrically conductive and may be electrically connected to a terminal of the electronic component. For example, second substrate 4 and further substrate 10 are both electrically conductive and are electrically connected to different terminals of the electronic component. In addition, further substrate 10 may comprise one or more further leads extending from the first portion or a second portion of further substrate, or may be electrically connected to one or more further leads different from one or more leads to which second substrate 4 is electrically connected. As a result, the first substrate (not visible in Figure 3D), second substrate 4 and further substrate 10 may each correspond to a respective terminal of the electronic component. Further substrate 10 may be comprised in a clip, similarly to second substrate 4.

In some embodiments, a plurality of recesses are formed, each extending up to the first portion of second substrate 4 or, if applicable, further substrate 10. In some embodiments, a single recess is formed extending up to both second substrate 4 and, if applicable, further substrate 10.

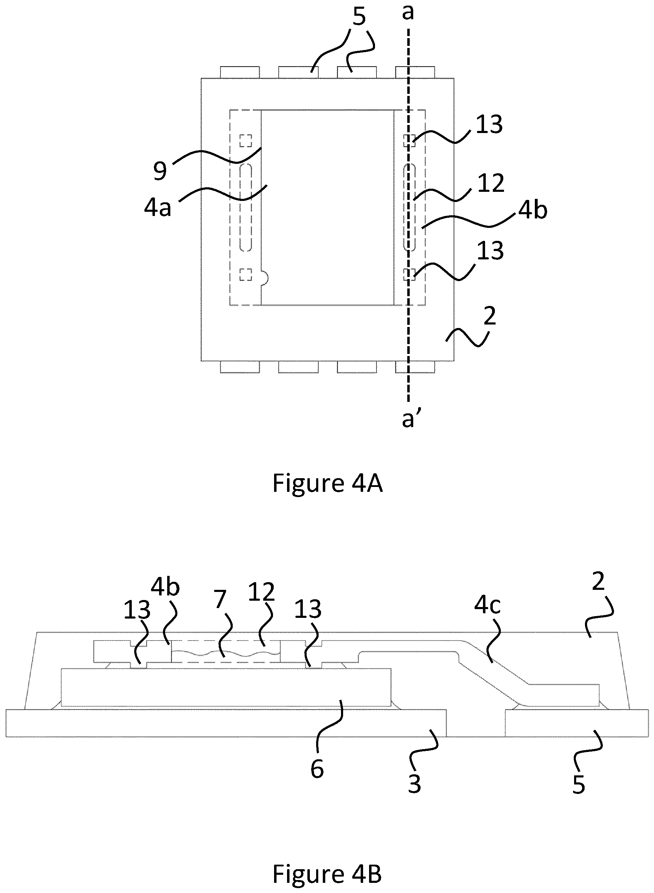

In Figure 4A, a top view of electronic package 1 is shown in accordance with an embodiment of the present disclosure. In Figure 4B, a corresponding cross-sectional view of electronic package 1 is shown along line a-a', as indicated in Figure 4A. For convenience, reference signs are shown for only some of the plurality of leads 5. It is noted that, in Figure 4A, part of second substrate 4b beneath package material 2 is shown using dotted lines.

In the embodiment shown in Figures 4A and 4B, second substrate 4 further comprises an overflow hole 12 arranged in second portion 4b extending through second substrate 4. Overflow hole 12 is arranged to receive attaching material 7 during attaching of second substrate 4 to electronic component 6 to prevent or limit a bleeding of attaching material towards electronic component 6.

In particular, during arranging second substrate 4 on electronic component 6 with attaching material 7 therebetween, part of attaching material 7 will enter and remain in overflow hole 12, preventing too much attaching material 7 from bleeding towards electronic component 6 or other components of electronic package 1. As a result, the manufacturing reliability of electronic package 1 can be improved.

Alternatively, an overflow recess (not shown) is arranged which does not extend fully through second substrate 4. Even though the overflow recess does not extend fully through second substrate 4, part of attaching material 7 may enter and remain in said overflow recess during attaching of second substrate 4 to electronic component 6, preventing or limiting the bleeding of attaching material 7.

In the embodiment shown in Figures 4A and 4B, second substrate 4 further comprises a plurality of protrusions 13 extending from second portion 4b to electronic component 6. The plurality of protrusions 13 define a space between second substrate 4 and electronic component 6 to more reliably provide a volume of attaching material 7 arranged therebetween. In other words, a desired bond line thickness (BLT) can be more reliably provided, improving the manufacturing reliability of electronic package 1.

Second portion 4b may be arranged to surround first portion 4a, and a plurality of protrusions 13 and overflow holes 12 may be arranged in second portion 4b on any side of first portion 4a. For example, as shown in Figure 4B, overflow holes 12 are provided in second portion 4b on either side of first portion 4a, and the plurality of protrusions 13 are also provided on either side of first portion 4a.

In the embodiment shown in Figures 4A and 4B, first portion 4a (or a coating and/or layer (stack) arranged thereon) is exposed through recess 9, whereas second portion 4b is covered by package material 2.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including various modifications and/or combinations of features from different embodiments, without departing from the scope of the present disclosure as defined by the appended claims.

## Claims

1. An electronic package, comprising:
a first substrate;
an electronic component arranged on and/or formed in the first substrate;
a thermally conductive second substrate comprising a first portion and a second portion integrally connected to the first portion, wherein at least the first portion among the first and second portion is fixedly attached to the electronic component; and
a package material arranged to encapsulate the electronic component and to at least partially encapsulate the first and second substrate, wherein the package material comprises a recess formed therein that extends up to a surface of the first portion.

2. The electronic package according to claim 1, wherein, viewed in a direction in which the recess extends towards the first portion, a contour of the recess is formed to allow unique identification of an orientation of the electronic package viewed in said direction.

3. The electronic package according to claim 1 or 2, wherein the second substrate is attached to the electronic component using an attaching material, such as tin.

4. The electronic package according to claim 3, wherein the second portion comprises an overflow recess or hole facing the electronic component, wherein the attaching material preferably occupies at least part of said overflow recess or hole.

5. The electronic package according to claim 3 or 4, wherein the second substrate comprises a plurality of protruding portions extending from the second portion to the electronic component defining a space between the electronic component and a remainder of the second substrate, said space being at least partially filled with the attaching material.

6. The electronic package according to any of the previous claims, wherein the electronic package comprises a plurality of leads for allowing electrical contact with the electronic package, wherein the second substrate is comprised in a clip, the clip further comprising a lead portion extending from the second portion to at least one lead among the plurality of leads, wherein the lead portion is electrically or integrally connected to said at least one lead, and wherein the clip electrically connects a terminal of the electronic component to said at least one lead; and/or
wherein the first substrate is electrically conductive and is electrically connected to a second terminal of the electronic component, wherein the first substrate is configured to allow electrical access to the second terminal of the electronic component.

7. The electronic package according to any of the previous claims, wherein the electronic component comprises a semiconductor die, and wherein the first substrate comprises a die pad; and/or
wherein the package material comprises a body of solidified molding compound; and/or
wherein the electronic package further comprises a conductive coating and/or layer stack arranged in the recess on the surface of the first portion, the conductive coating and/or layer stack preferably comprising tin.

8. A method for manufacturing an electronic package, the method comprising:
a) providing an electronic package comprising:
a first substrate;
an electronic component arranged on and/or formed in the first substrate;
a thermally conductive second substrate comprising a first portion and a second portion integrally connected to the first portion, wherein at least the first portion among the first and second portion is fixedly attached to the electronic component; and
a package material arranged to encapsulate the electronic component and to at least partially encapsulate the first and second substrate; and
b) forming a recess in the package material extending up to a surface of the first portion.

9. The method according to claim 8, wherein, viewed in a direction in which the recess extends towards the first portion, a shape of a contour of the recess is formed to allow unique identification of an orientation of the electronic package viewed in said direction.

10. The method according to claim 8 or 9, wherein step b) comprises:
arranging a masking layer configured to define a position and shape of the recess, etching the package material using the masking layer, and removing the masking layer, wherein the etching preferably comprises chemical etching and wherein the masking layer preferably comprises a metal such as aluminum or copper; and/or
applying a laser to laser-remove a portion of the package material.

11. The method according to any of the claims 8-10, wherein step a) comprises:
a1) providing the first substrate;
a2) arranging the electronic component on the first substrate;
a3) attaching at least the first portion among the first and second portion to the electronic component; and
a4) providing the package material, wherein step a4) preferably comprises applying a molding compound and allowing said molding compound to solidify to thereby form a body of solidified molding compound, the body of solidified molding compound forming the package material of the electronic package,
wherein the first substrate is preferably comprised in a leadframe, the leadframe comprising a frame portion and a plurality of said first substrates connected to the frame portion for manufacturing a plurality of respective electronic components, and wherein the method preferably further comprises singulating the electronic package from the frame portion after step a4).

12. The method according to any of the claims 8-11, wherein the second substrate is attached to the electronic component using an attaching material, such as tin.

13. The method according to claim 12, wherein the second portion comprises an overflow recess or hole facing the electronic component, wherein the attaching material preferably occupies at least part of said overflow recess or hole.

14. The method according to claim 12 or 13, wherein the second substrate comprises a plurality of protruding portions extending from the second portion to the electronic component defining a space between the electronic component and a remainder of the second substrate, said space being at least partially filled with the attaching material.

15. The method according to any of the claims 8-14, further comprising arranging a conductive coating and/or layer stack in the recess on the surface of the first portion, the conductive coating and/or layer stack preferably comprising tin; and/or
wherein the electronic package comprises a plurality of leads for allowing electrical contact with the electronic package, wherein the second substrate is comprised in a clip, the clip further comprising a lead portion extending from the second portion to at least one lead among the plurality of leads, wherein the lead portion is electrically or integrally connected to said at least one lead, and wherein the clip electrically connects a terminal of the electronic component to said at least one lead; and/or
wherein the first substrate is electrically conductive and is electrically connected to a second terminal of the electronic component, wherein the first substrate is configured to allow electrical access to the second terminal of the electronic component; and/or
wherein the electronic component comprises a semiconductor die, and wherein the first substrate comprises a die pad.
